# EUROPÄISCHE PATENTSCHRIFT

(11) **EP 3 015 869 B1**
(45) Veröffentlichungstag und Bekanntmachung des Hinweises auf die Patenterteilung: **22.02.2017**
(21) Anmeldenummer: 15190706.0
(22) Anmeldetag: 21.10.2015
(51) Int. Cl.: G01R 1/067, H01R 12/71, H01R 13/24

(54) **FEDERKONTAKTVORRICHTUNG**
SPRING CONTACT DEVICE
DISPOSITIF DE CONTACT A RESSORT

(30) Priorität: 28.10.2014 DE 202014105151 U
(43) Veröffentlichungstag der Anmeldung: 04.05.2016
(73) Patentinhaber: PTR Messtechnik GmbH, 59368 Werne (DE)
(72) Erfinder: BRIESEMANN, Andreas, 44534 Lünen (DE)
(74) Vertreter: Meinke, Dabringhaus und Partner GbR

(56) Entgegenhaltungen:
- US-A1- 2006 028 224
- US-A1- 2006 279 301
- US-A1- 2009 075 529

## Beschreibung

Die Erfindung betrifft eine Federkontaktvorrichtung zur Kontaktierung von elektronischen Komponenten zur Durchführung einer Vierleitermessung mit wenigstens einem Federkontaktstift, welcher ein elektrisch leitfähiges Gehäuse aufweist, in welchem ein von einer Feder beaufschlagter elektrisch leitfähiger Kolben geführt ist, dessen Kolbenkopf in elektrischem Kontakt mit der elektronischen Komponente bringbar ist.

Bei der Prüfung von elektronischen Komponenten mit sehr kleinen Widerständen bzw. hohen Genauigkeitsanforderungen an die Prüfung müssen Leitungs-und Anschlusswiderstände eliminiert werden. Dazu wird in der Regel die sogenannte Vierleitermessung (auch Vierpolmessung oder Kelvin-Messung genannt) verwendet. Bei der Vierleitermessung fließt über zwei der Leitungen ein bekannter elektrischer Strom durch den Widerstand. Die am Widerstand abfallende Spannung wird hochohmig über zwei weitere Leitungen abgegriffen und mit einem Spannungsmessgerät gemessen. Der zu messende Widerstand wird daraus nach dem Ohmschen Gesetz berechnet.

Zur Durchführung dieser Vierleitermessung benutzt man bei manueller Prüfung, z.B. sogenannte Vierpolklemmen. Bei einer automatisierten Prüfung über einen Testadapter oder ähnliche Vorrichtungen werden dagegen üblicherweise Federkontaktstifte eingesetzt, die eine sichere und schnelle Kontaktierung ermöglichen. Ist eine Vierleitermessung erforderlich, so müssen auf jeden der zwei Anschlusspunkte der elektronischen Komponente zwei dieser Federkontaktstifte aufgesetzt werden. Dies ist aus Platzgründen, insbesondere auch im Hinblick auf die zunehmende Miniaturisierung, teils nur unter erhöhten Aufwendungen bzw. Verschleiß der Federkontakte (z.B. durch Schrägstellung der Federkontakte) oder gar nicht mehr möglich.

Zur Lösung dieser Problematik ist bereits aus DE 10 2007 006 515 A1 eine spezielle Federkontaktvorrichtung bekannt geworden, die in einem Gehäuse zwei nebeneinander angeordnete speziell gestaltete Federkontakte aufweist, wobei jeder Federkontakt jeweils einen ersten geradlinigen Kontaktabschnitt und einen zweiten geradlinigen Kontaktabschnitt aufweist, zwischen denen ein Federabschnitt vorgesehen ist. Diese spezielle Kontaktvorrichtung ist zwar für den Einsatz bei einer Vierleitermessung geeignet, jedoch aufgrund ihrer speziellen Gestaltung aufwendig herzustellen.

Es ist deshalb wünschenswert, eine Vierleitermessung auch mit üblichen Federkontaktstiften durchführen zu können.

Aufgabe der Erfindung ist es deshalb, eine Federkontaktvorrichtung der eingangs bezeichneten Art so weiter zu entwickeln, dass sie auch für Vierleitermessungen mit geringem Raumbedarf an der Messstelle geeignet ist.

Diese Aufgabe wird bei eine Federkontaktvorrichtung der eingangs bezeichneten Art erfindungsgemäß dadurch gelöst, dass wenigstens zwei nebeneinander angeordnete Federkontaktstifte vorgesehen sind, deren Kolbenköpfe fest und elektrisch leitend mit einer elektrisch leitenden Kontaktbrücke verbunden sind, welche auf der den Kolbenköpfen abgewandten Seite zur Kontaktierung der elektronischen Komponente ausgebildet ist.

Es wird somit eine Federkontaktvorrichtung mit zwei Anschlussleitungen, aber nur einem einzigen Kontaktpunkt zur Verfügung gestellt, welche im Prinzip aus Standardbauteilen, nämlich zwei herkömmlichen Federkontaktstiften aufgebaut ist, deren Kolbenköpfe elektrisch leitend mit einer elektrisch leitenden Kontaktbrücke verbunden sind. Die Kontaktbrücke gelangt beim Mess- bzw. Prüfvorgang in Kontakt mit dem Anschlusspol der Vierleitermessung, wobei über den Kolben des einen Federkontaktstiftes ein Strom zugeführt wird und der andere Kolben des anderen Federkontaktstiftes zum Abgreifen der abfallenden Spannung genutzt wird. Zur Durchführung einer Vierleitermessung sind somit zwei erfindungsgemäße Kontaktvorrichtungen notwendig. Dadurch, dass die Federkontaktvorrichtung nur ein Kontaktelement für jeden Anschlusspol der Vierleitermessung aufweist, ist eine Miniaturisierung möglich und die Vorrichtung ist auch für kleine Raster geeignet. Die Federkontaktvorrichtung kann für andere Anwendungsfälle auch mehr als zwei Federkontaktstifte aufweisen, wenn mehrere Anschlüsse auf einen Kontaktpunkt zugeführt werden sollen.

Zur Verbindung der Kolbenköpfe der beiden Federkontaktstifte mit der Kontaktbrücke ist bevorzugt vorgesehen, dass die Kontaktbrücke auf der den Kolbenköpfen zugewandten Seite wenigstens zwei benachbarte Aufnahmebohrungen für die Kolbenköpfe aufweist. In diese Aufnahmebohrungen werden die beiden Kolbenköpfe eingesetzt und fest mit der Kontaktbrücke verbunden.

Diese feste elektrisch leitende Verbindung kann grundsätzlich auf beliebige kraft, form- oder stoffschlüssige Art erfolgen.

Bevorzugt ist vorgesehen, dass die Kolbenköpfe in die Aufnahmebohrungen eingelötet, eingeschweißt oder elektrisch leitfähig verklebt sind.

Alternativ können die Kolbenköpfe in die Aufnahmebohrungen eingeschraubt sein oder auch eingepresst oder eingequetscht sein.

Je nach Ausgestaltung des jeweiligen Anschlusspoles der Vierleitermessung kann der Kontaktbereich der Kontaktbrücke unterschiedlich ausgestaltet sein.

Nach einer ersten Ausgestaltung ist vorgesehen, dass die Kontaktbrücke auf der den Kolbenköpfen abgewandten Seite eine Kontaktspitze aufweist. Diese Kontaktspitze wird dann auf den Anschlusspol aufgedrückt. Die Kontaktspitze kann jede bei Federkontaktstiften übliche Form aufweisen (z.B. waffelförmig, 90° Innenkegel, flach).

Alternativ kann vorgesehen sein, dass die Kontaktbrücke auf der den Kolbenköpfen abgewandten Seite eine Kontaktausnehmung mit Schneidkanten aufweist. Eine solche Ausführungsform eignet sich besonders zur Kontaktierung von runden Prüfungsquerschnitten.

Dabei ist bevorzugt vorgesehen, dass die Kontaktbrücke zwei Brückenteile aufweist, wobei jedes Brückenteil mit einem Kolbenkopf verbunden ist und beide Brückenteile elektrisch leitend und fest miteinander verbunden sind.

Die Erfindung ist nachstehend anhand der Zeichnung beispielhaft näher erläutert.

Diese zeigt jeweils in stark vergrößertem Maßstab in
- Fig. 1: eine Seitenansicht auf eine Federkontaktvorrichtung nach einer ersten Ausgestaltung,
- Fig. 2: die Federkontaktvorrichtung nach Figur 1 von der Seite,
- Fig. 3: einen Schnitt gemäß der Linie A-A in Figur 2,
- Fig. 4: eine Seitenansicht auf eine Federkontaktvorrichtung nach einer zweiten Ausgestaltung und
- Fig. 5: eine Ansicht von rechts auf die Federkontaktvorrichtung nach Figur 4.

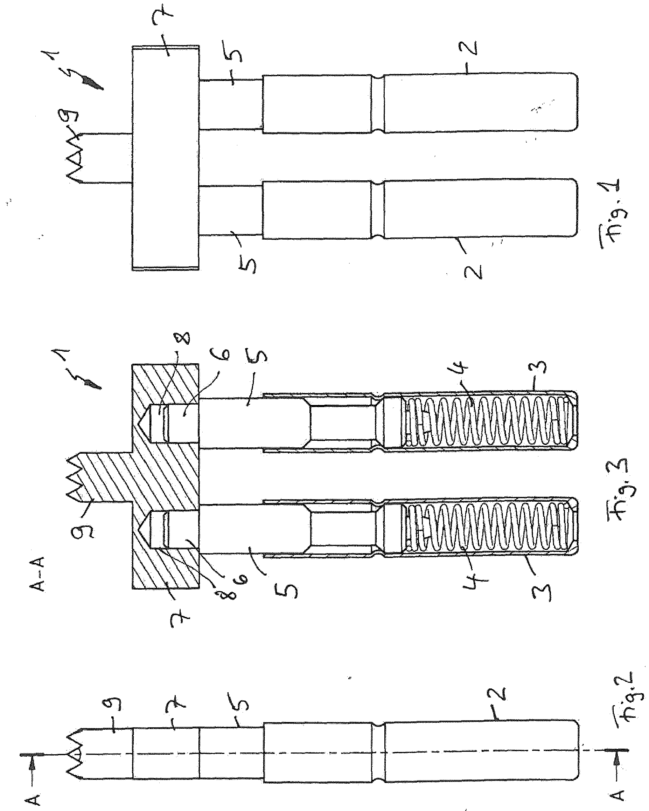

In den Figuren 1 bis 3 ist eine erste Ausführungsform einer erfindungsgemäßen Federkontaktvorrichtung zur Durchführung einer Vierleitermessung dargestellt.

Die Federkontaktvorrichtung 1 weist zwei Federkontaktstifte 2 auf, die vom Aufbau her üblichen Federkontaktstiften entsprechen. Jeder Federkontaktstift 2 weist dabei ein elektrisch leitfähiges Gehäuse 3 mit einem nicht dargestellten elektrischen Anschluss zum Anschließen an eine Stromquelle oder ein Messgerät, insbesondere Spannungsmessgerät auf, in welchem ein von einer Feder 4 beaufschlagter elektrisch leitfähiger Kolben 5 geführt ist, wobei jeder Kolben 5 nach vorne aus dem rohrförmigen Gehäuse 3 heraussteht und freiendseitig einen Kolbenkopf 6 aufweist.

Wesentlich für die Federkontaktvorrichtung 1 ist nun, dass die Kolbenköpfe 6 der beiden nebeneinander angeordneten Federkontaktstifte 2 fest und elektrisch leitend mit einer elektrisch leitenden Kontaktbrücke 7 verbunden sind.

Die Kontaktbrücke 7 weist dazu in einem vorgebbaren Abstand zwei Aufnahmebohrungen 8 auf, in welche die Kolbenköpfe 6 beider Federkontaktstifte 2 fest und elektrisch leitend eingesetzt sind. Die feste und elektrisch leitende Verbindung kann dabei grundsätzlich auf beliebige kraft-, form- oder stoffschlüssige Weise erfolgen, z.B. durch Einlöten, Verschweißen, elektrisch leitfähiges Verkleben, Einschrauben, Quetschen und/oder Verpressen.

Die Kolbenköpfe 6 weisen für eine bessere Verbindung mit der Kontaktbrücke 7 beim Ausführungsbeispiel nach Figuren 1 bis 3 einen gegenüber dem angrenzenden Durchmesser der Kolben 5 verringertem Durchmesser auf.

Auf der den Aufnahmebohrungen 8 abgewandten Seite ist die Kontaktbrücke 7 zur Kontaktierung einer elektronischen Komponente, bei einer Vierleitermessung also zur Kontaktierung eines Anschlusspols ausgebildet, und zwar bei diesem Ausführungsbeispiel in Form einer Kontaktspitze 9.

Zur Durchführung einer Vierleitermessung werden zwei erfindungsgemäße Federkontaktvorrichtungen 1 benötigt, wobei die jeweilige Kontaktspitze 9 jeweils mit einem Anschlusspol in Kontakt gebracht wird. Über einen Federkontaktstift 1 wird ein Messstrom zum Anschlusspol geleitet und über den anderen Federkontaktstift 2 derselben Federkontaktvorrichtung 1 wird die abfallende Spannung abgegriffen und von einem Spannungsmessgerät gemessen, das an das Gehäuse 3 des betreffenden Federkontaktstiftes 2 angeschlossen ist.

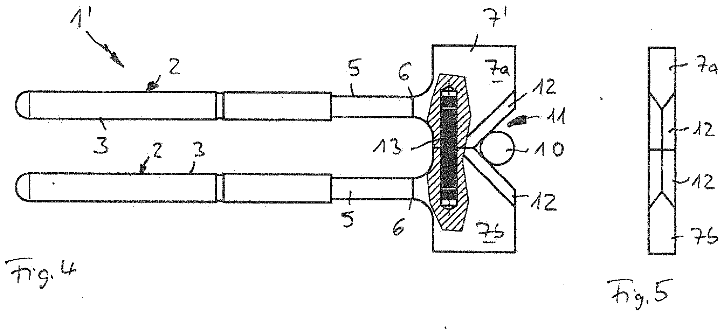

In den Figuren 4 und 5 ist eine zweite Ausführungsform einer erfindungsgemäßen Federkontaktvorrichtung dargestellt, wobei dieselben Bezugszeichen wie in den Figuren 1 bis 3 verwandt sind, sofern gleiche Teile betroffen sind. Bei ähnlicher Ausgestaltung ist der Zusatz " ' " hinzugefügt,

Die Federkontaktvorrichtung 1' unterscheidet sich durch die andere Ausführung der Kontaktbrücke 7', die zur Kontaktierung eines querschnittlich runden Anschlusskontakten 10 dient. Dazu weist die Kontaktbrücke 7' auf der den Kolbenköpfen 6 abgewandten Seite eine Kontaktausnehmung 11 mit Schneidkanten 12 auf.

Ansonsten kann der Aufbau der Kontaktbrücke 7' genauso sein wie derjenige der Kontaktbrücke 7 nach Figuren 1 bis 3.

Beim in den Figuren 4 und 5 dargestellten speziellen Ausführungsbeispiel ist der Aufbau der Kontaktbrücke 7' jedoch anders. Die Kontaktbrücke 7' ist zweigeteilt. Sie besteht aus zwei Brückenteilen 7a, 7b, wobei das jeweilige Brückenteil 7a bzw. 7b vorzugsweise einstückig (ggf. aber auch mehrstückig) mit dem jeweiligen Kolbenkopf 6 des zugeordneten Federkontaktstiftes 2 verbunden ist. Die beiden Brückenteile 7a, 7b sind untereinander mittels eines Bolzens 13 elektrisch leitend und fest miteinander verbunden. Weitere Ausgestaltungsmöglichkeiten dieser Verbindung sind ausgeklinkte und verpresste Geometrien zwischen den beiden Brückenteilen 7a, 7b oder stoffschlüssige Verbindungen, wie Löten, Schweißen oder elektrisch leitfähiges Verkleben.

Natürlich ist die Erfindung nicht auf die dargestellten Ausführungsbeispiele beschränkt. Weitere Ausgestaltungen sind möglich, ohne den Grundgedanken zu verlassen.

### Bezugszeichenliste

- 1: Federkontaktvorrichtung
- 2: Federkontaktstifte
- 3: leitfähiges Gehäuse
- 4: Feder
- 5: leitfähiger Kolben
- 6: Kolbenköpfe
- 7, 7': Kontaktbrücke
- 7a: Brückenteil
- 7b: Brückenteil
- 8: Aufnahmebohrungen
- 9: Kontaktspitze
- 10: runder Anschlusskontakt
- 11: Kontaktausnehmung
- 12: Schneidkanten
- 13: Bolzen

## Patentansprüche

1. Federkontaktvorrichtung (1) zur Kontaktierung von elektronischen Komponenten zur Durchführung einer Vierleitermessung mit wenigstens einem Federkontaktstift (2), welcher ein elektrisch leitfähiges Gehäuse (3) aufweist, in welchem ein von einer Feder (4) beaufschlagter elektrisch leitfähiger Kolben (5) geführt ist, dessen Kolbenkopf (6) in elektrischem Kontakt mit der elektronischen Komponente bringbar ist,
**dadurch gekennzeichnet,**
**dass** wenigstens zwei nebeneinander angeordnete Federkontaktstifte (2) vorgesehen sind, deren Kolbenköpfe (6) fest und elektrisch leitend mit einer elektrisch leitenden Kontaktbrücke (7,7') verbunden sind, welche auf der den Kolbenköpfen (6) abgewandten Seite zur Kontaktierung der elektronischen Komponente ausgebildet ist.

2. Federkontaktvorrichtung nach Anspruch 1,
**dadurch gekennzeichnet,**
**dass** die Kontaktbrücke (7) auf der den Kolbenköpfen (6) zugewandten Seite wenigstens zwei benachbarte Aufnahmebohrungen (8) für die Kolbenköpfe (6) aufweist.

3. Federkontaktvorrichtung nach Anspruch 1 oder 2,
**dadurch gekennzeichnet,**
**dass** die Kolbenköpfe (6) in die Aufnahmebohrungen (8) eingelötet, eingeschweißt oder elektrisch leitfähig verklebt sind.

4. Federkontaktvorrichtung nach Anspruch 2,
**dadurch gekennzeichnet,**
**dass** die Kolbenköpfe (6) in die Aufnahmebohrungen (8) eingeschraubt sind.

5. Federkontaktvorrichtung nach Anspruch 2,
**dadurch gekennzeichnet,**
**dass** die Kolbenköpfe (6) in die Aufnahmebohrungen (8) eingepresst oder eingequetscht sind.

6. Federkontaktvorrichtung nach einem oder mehreren der Ansprüche 1 bis 5,
**dadurch gekennzeichnet,**
**dass** die Kontaktbrücke (7) auf der den Kolbenköpfen (6) abgewandten Seite eine Kontaktspitze (9) aufweist.

7. Federkontaktvorrichtung nach einem oder mehreren der Ansprüche 1 bis 5,
**dadurch gekennzeichnet,**
**dass** die Kontaktbrücke (7') auf der den Kolbenköpfen (6) abgewandten Seite eine Kontaktausnehmung (11) mit Schneidkanten (12) aufweist.

8. Federkontaktvorrichtung nach Anspruch 7,
**dadurch gekennzeichnet,**
**dass** die Kontaktbrücke (7') zwei Brückenteile (7a, 7b) aufweist, wobei jedes Brückenteil (7a, 7b) mit einem Kolbenkopf (6) verbunden ist und beide Brückenteile (7a, 7b) elektrisch leitend und fest miteinander verbunden sind.

## Claims

1. Spring contact device (1) for contacting electronic components for performing a four-wire measurement with at least one spring contact pin (2), which has an electro conductive housing (3), in which an electro conductive piston (5) loaded by a spring (4) is guided, the piston head (6) of which can be moved into electrical contact with the electronic component,
**characterised in that**
at least two adjacently arranged spring contact pins (2) are provided, the piston heads (6) of which are connected securely and electro conductively to an electro conductive contact bridge (7,7'), which is formed on the side facing away from the piston heads (6) for contacting the electronic component.

2. Spring contact device according to claim 1,
**characterised in that**
the contact bridge (7) comprises at least two adjacent receiving bores (8) for the piston heads (6) on the side facing the piston heads (6).

3. Spring contact device according to claim 1 or 2,
**characterised in that**
the piston heads (6) are soldered, welded or adhered electro conductively into the receiving bores (8).

4. Spring contact device according to claim 2,
**characterised in that**
the piston heads (6) are screwed into the receiving bores (8).

5. Spring contact device according to claim 2,
**characterised in that**
the piston heads (6) are pressed or squeezed into the receiving bores (8).

6. Spring contact device according to one or more of claims 1 to 5,
**characterised in that**
the contact bridge (7) has a contact tip (9) on the side facing away from the piston heads (6).

7. Spring contact device according to one or more of claims 1 to 5,
**characterised in that**
the contact bridge (7') comprises a contact recess (11) with cutting edges (12) on the side facing away from the piston heads (6).

8. Spring contact device according to claim 7,
**characterised in that**
the contact bridge (7') comprises two bridge parts (7a, 7b), wherein each bridge part (7a, 7b) is connected to a piston head (6) and both bridge parts (7a, 7b) are connected to one another electro conductively and securely.

## Revendications

1. Dispositif de contact à ressorts (1) servant à établir un contact entre des composants électroniques pour la mise en oeuvre d'une mesure à quatre conducteurs avec au moins une tige de contact à ressorts (2), qui présente un boîtier (3) électroconducteur, dans lequel un piston (5) électroconducteur pouvant être soumis à l'action d'un ressort (4) est guidé, dont la tête de piston (6) peut être amenée en contact électrique avec le composant électronique,
**caractérisé en ce**
**qu'**au moins deux tiges de contact à ressorts (2) disposées de manière juxtaposée sont prévues, dont les têtes de piston (6) sont reliées de manière solidaire et de manière électroconductrice à un pont de contact (7, 7') électroconducteur, lequel est réalisé sur le côté opposé aux têtes de piston (6) afin d'établir un contact avec le composant électronique.

2. Dispositif de contact à ressorts selon la revendication 1,
**caractérisé en ce**
**que** le pont de contact (7) présente, sur le côté tourné vers les têtes de piston (6), au moins deux alésages de réception (8) adjacents pour les têtes de piston (6).

3. Dispositif de contact à ressorts selon la revendication 1 ou 2,
caractérisé e ce
que les têtes de piston (6) sont introduites par brasage, par soudage dans les alésages de réception (8) ou sont collées de manière électroconductrice.

4. Dispositif de contact à ressorts selon la revendication 2,
**caractérisé en ce**
**que** les têtes de piston (6) sont introduites par vissage dans les alésages de réception (8).

5. Dispositif de contact à ressorts selon la revendication 2,
**caractérisé en ce**
**que** les têtes de piston (6) sont introduites par pression ou par écrasement dans les alésages de réception (8).

6. Dispositif de contact à ressorts selon l'une quelconque ou plusieurs des revendications 1 à 5,
**caractérisé en ce**
**que** le pont de contact (7) présente, sur le côté opposé aux têtes de piston (6), une pointe de contact (9).

7. Dispositif de contact à ressorts selon l'une quelconque ou plusieurs des revendications 1 à 5,
**caractérisé en ce**
**que** le pont de contact (7') présente, sur le côté opposé aux têtes de piston (6), un évidement de contact (11) avec des arêtes coupantes (12).

8. Dispositif de contact à ressorts selon la revendication 7,
**caractérisé en ce**
**que** le pont de contact (7') présente deux parties de pont (7a, 7b), dans lequel chaque partie de pont (7a, 7b) est reliée à une tête de piston (6) et les deux parties de pont (7a, 7b) sont reliées de manière électroconductrice et de manière solidaire l'une à l'autre.
